# EUROPEAN PATENT SPECIFICATION

(11) **EP 1 677 374 B1**
(45) Date of publication and mention of the grant of the patent: **11.09.2013**
(21) Application number: 05111624.2
(22) Date of filing: 02.12.2005
(51) Int. Cl.: H01L 51/05, H01L 51/40

(54) **Method of manufacturing an organic thin film transistor**
Herstellungsverfahren für organischen Dünnfilmtransistor
Méthode pour la fabrication d'un transistor organique à couche mince

(30) Priority: 04.12.2004 KR 2004101523
(43) Date of publication of application: 05.07.2006
(73) Proprietor: Samsung Display Co., Ltd., Yongin-City, Gyeonggi-Do, 446-711 (KR)
(72) Inventor: Suh, Min-Chul, Gyeonggi-do (KR); Koo, Jae-Bon Legal & IP Team, Samsung SDI Co., Ltd, Gyeonggi-do (KR); Mo, Yeon-Gon, Gyeonggi-do (KR); Ahn, Teak, Gyeonggi-do (KR); Jeong, Jong-Han, Gyeonggi-do (KR)
(74) Representative: Hengelhaupt, Jürgen

(56) References cited:
- EP-A- 1 434 282
- WO-A-2004/070821
- WO-A1-99/11105
- JP-A- 3 262 187
- US-A- 5 492 863
- US-A1- 2004 206 942

## Description

### CLAIM OF PRIORITY

This application makes reference to and claims all benefits accruing under 35 U.S.C. §119 from an application earlier filed in the Korean Intellectual Property Office on December 4, 2004 and there duly assigned Serial No. 10-2004-0101523.

### BACKGROUND OF THE INVENTION

### Field of the Invention

The present invention relates to a method of manufacturing a thin film transistor as described in claims 1-6.

### Description of the Related Art

In general, light emitting devices, which are a kind of flat panel display device, are next-generation display devices due to the advantages of large viewing angle, high contrast property, and short response time. Such light emitting devices are classified into inorganic light emitting devices and organic light emitting devices (OLEDs) according to the material used in their emission layer.

OLEDs are self-luminous display devices which emit light when a fluorescent organic compound is electrically excited. OLEDs can operate at a low voltage, can be manufactured to be thin, have a wide viewing angle and a short response time, and thus are receiving attention as a next-generation display which can overcome problems arising with conventional displays, such as liquid crystal displays.

An OLED includes an emission layer having an organic material between an anode electrode and a cathode electrode. In the OLED, as a voltage is applied across the anode and cathode electrodes, holes migrate from the anode electrode to the emission layer through a hole transporting layer, while electrons migrate from the cathode electrode to the emission layer through an electron transporting layer. The holes and electrons recombine in the emission layer and thus generate exitons. When the exitons transit from an exited state to a base state, fluorescent molecules in the emission layer emit light, thus forming images. A full-color OLED includes pixels, each emitting light of three colors, i.e., red, green, and blue, and thus can realize full-color images.

A flat display device, such as an OLED, an inorganic light emitting device, etc, includes a thin film transistor (TFT) as a switching device for controlling the operation of each pixel and a device for driving each pixel. The TFT includes a semiconductor layer in which source and drain regions are heavily doped with impurities and a channel region between the source and drain regions are defined, a gate electrode which is formed in a region corresponding to the channel region while being insulated from the semiconductor layer, and source/drain electrodes which respectively contact the source and drain regions.

Recently, a thin film structure and flexibility have been required for flat display devices. To realize the flexibility requirement, a plastic substrate has been used instead of a conventional glass substrate for a flat panel display device. However, plastic substrates can be used only at low temperatures. For this reason, organic thin film transistors including organic semiconductor layers have become more prevalent than other polysilicon thin film transistors. Organic semiconductor layers can be formed using only low-temperature processes and can be used to make low-cost thin film transistors. An example of such an organic semiconductor layer is disclosed in U.S. Patent No. 6,433,359 to Kelley et al.

In an organic thin film transistor, conductive layers, for example, a gate electrode, a gate conductive layer connected to the gate electrode, source and drain electrodes, source and drain conductive layers connected to the source or drain electrode, etc., are formed using, for example, a deposition method. However, the organic thin film transistor manufactured using this deposition method is expensive. Furthermore, the substrate or organic semiconductor layers are damaged by heat generated during the deposition process. Therefore, what is needed is an improved design for an organic thin film transistor and an improved method of making the same that is less apt to subject the substrate to heat, is inexpensive and can be used in a roll-to-roll process.

In WO99/11105 a carrier liquid coating containing metal particles is applied to a substrate. The coating is then structured to form electroconductive structures. The carrier liquid is a non polymerized thermoplastic which is thermally or optically polymerized at corresponding positions to form structures. Polymerization can occur by means of a laser beam.

JP3262187 discloses a method wherein conductor paste is applied onto a ceramic wiring board, laser rays in wavelength of an infrared range are made to irradiate the board scanning its surface to solidify the paste for the formation of a pattern, and the disused paste is removed.

In W02004/070821 A1 a droplet containing conductive particles is jetted onto a film to be treated by using a first droplet jet apparatus, a conductive film is thereby formed, a resist pattern is locally formed on the conductive film by using a second droplet jet apparatus, the conductive film is etched by using the resist pattern as a mask, and thus a wiring is fabricated.

### SUMMARY OF THE INVENTION

It is an object of the present invention to provide an improved method of making an organic thin film transistor suitable for flexible plastic substrates.

The method includes preparing a curable paste composition comprising conductive nano-particles, a curable resin, and a vehicle, applying the curable paste composition to a substrate, curing a portion of the curable paste composition to define at least one pattern of a gate electrode, a first conductive layer connected to the gate electrode, source and drain electrodes, and a second conductive layer connected to one of the source and drain electrodes and removing an uncured portion of the curable paste composition to form the at least one of the gate electrode, the first conductive layer, the source and drain electrode, and the second conductive layer.

A thin film transistor with a fine conductive layer pattern can be manufactured through low-cost, low-temperature roll-to-roll continuous processes using the method according to the present invention. In addition, the organic semiconductor layer and the substrate of the thin film transistor are not substantially damaged during the manufacturing process.

### BRIEF DESCRIPTION OF THE DRAWINGS

A more complete appreciation of the invention, and many of the attendant advantages thereof, will be readily apparent as the same becomes better understood by reference to the following detailed description when considered in conjunction with the accompanying drawings in which like reference symbols indicate the same or similar components, wherein:

FIG. 1 is a plan view of a thin film transistor ;

FIG. 2 is a sectional view of the thin film transistor taken along line I-I in FIG. 1;

FIG 3 is a sectional view of a flat panel display ; and

FIG. 4 is a transmission electron microscopic (TEM) photograph of a first conductive layer in a thin film transistor .

### DETAILED DESCRIPTION OF THE INVENTION

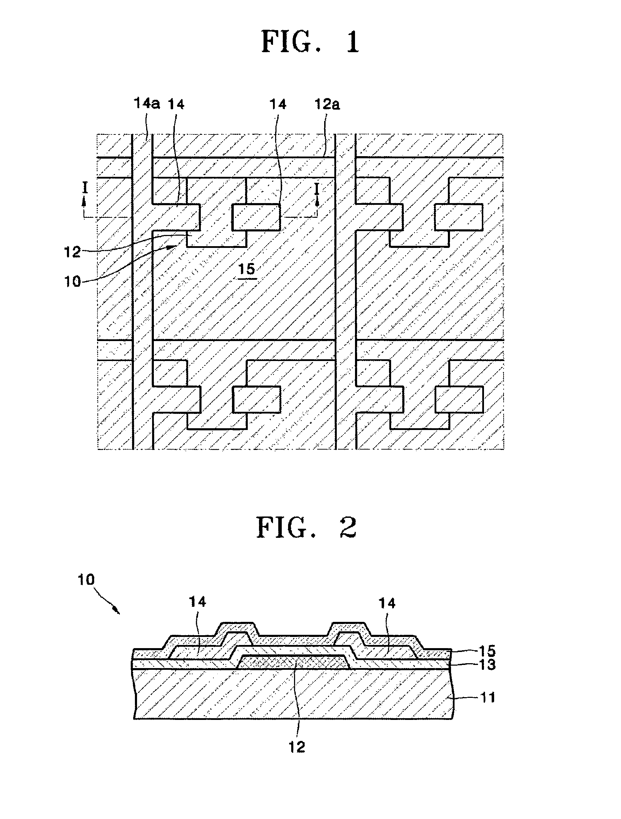

Turning now to the figures, FIG. 1 is a plan view of a thin film transistor 10 and FIG. 2 is a sectional view of the thin film transistor taken long line I-I in FIG. 1. The thin film transistor (TFT) 10 according to FIGS. 1 and 2 is formed on a substrate 11. The substrate 11 can be a glass substrate or a plastic substrate made of, for example, acryls, epoxys, polyamides, polycarbonates, polyimides, polyketones, polynorbonenes, polyphenylene oxides, polyethylene naphthalene dicarboxylates, polyethylene terephthalates (PET), polyphenylene sulfides (PPS), etc.

A gate electrode 12 is formed in a predetermined pattern on the substrate 11. An insulating layer 13 is formed such as to cover the gate electrode 12. Source and drain electrodes 14 are formed on the insulating layer 13. Although the source and drain electrodes 14 overlap portions of the gate electrode 12 as in FIG. 1, the present invention is not limited as such. Reference numeral 12a denotes a first conductive layer connected to the gate electrode 12 to supply a gate signal thereto, and reference numeral 14a denotes a second conductive layer connected to one of the source and drain electrodes 14. In the present invention, at least one of the gate electrode 12, the first conductive layer 12a, the source and drain electrodes 14, and the second conductive layer 14a contains both conductive nano-particles and a cured resin. The conductive nano-particles can be Au, Ag, Cu, Ni, Pt, Pd, Al nano-particles or a combination thereof but the present invention is in no way so limited.

The specific surface area of the conductive nano-particles are in a range of 2.0-10.0 m²/g, for example, 3.0-9.0 m²/g. In addition, the average particle diameter of the conductive nano-particles are in a range of 10-100 nm, for example, 20-90 nm. When the specific surface area of the conductive nano-particles is less than 2.0 m²/g or when the average particle diameter is larger than 100 nm, the linearity of the gate electrode, the first conductive layer, the source and drain electrodes, or the second conductive layer deteriorate, and the resistance increases. On the contrary, when the specific surface area of the conductive nano-particles is larger than 10.0 m²/g or when the average particle diameter is less than 10 nm, the conductive layer containing the nano-particles cannot have sufficient conductivity.

The conductive nano-particles can have lamellar, amorphous, or spherical shapes. For example, the conductive nano-particles can have spherical shapes in consideration of specific surface area, filling ratio, etc.

The cured resin is obtained by curing a curable resin via heat or exposure to light. The cured resin should be able to provide conductivity to the conductive layers, such as the gate electrode, the first conductive layer, the source and drain electrodes, the second conductive layer, etc., or at least should not reduce the conductivity of the conductive nano-particles.

The cured resin is obtained by curing a curable resin by exposure to laser radiation. When using a laser to cure resin, an ultra-fine pattern of cured resin results.

Examples of curable resins used to obtain the cured resin include phthalate resins, epoxy resins, urea resins, melamine resins, acetylene resins, pyrrole resins, thiophene resins, olefin resins, alcohol resins, phenol resins, and a combination of at least two of these resins. Specific examples of the curable resin include polyethylene phthalate, polybutylene phthalate, polydihydroxymethylcyclohexyl terephthalate, urea-formaldehyde resin, melamine (2,4,6-triamino-1,3,5-triazine)-formaldehyde resin, melamine-urea resin, melamine-phenol resin, polyacetylene, polypyrrole, poly(3-alkylthiophene), polyphenylene vinylidene, polyethylene vinylidene, polyvinyl alcohol, and photoresist resins, however, in no way is the present invention limited to these materials.

At least one of the gate electrode 12, the first conductive layer 12a, the source and drain electrodes 14, and the second conductive layer 14a has a surface roughness of 5-500Å, for example, 10-300Å (10 Å = 1 nm). If the surface roughness of a conductive region, such as the gate electrode 12, the first conductive layer 12a, the source and drain electrodes 14, and the second conductive layer 14a does not lie within the above range, contact failure between another layer, such as an organic layer formed on the conductive region and the conductive region can occur.

An organic semiconductor layer 15 is formed on the source and drain electrodes 14. Examples of organic semiconductor materials for the organic semiconductor layer 15 include pentacene, tetracene, anthracene, naphthalene, α-6- thiophene, α-4-thiophene, perylene and its derivative, rubrene and its derivative, coronene and its derivative, perylene tetracarboxylic diimide and its derivative, perylene tetracarboxylic dianhydride and its derivative, polythiophene and its derivative, polyparaphenylene vinylene and its derivative, polyparaphenylene and its derivative, polyfluorene and its derivative, polythiophene vinylene and its derivative, polythiophene-heterocyclic aromatic copolymer and its derivative, oligoacene of naphthalene and their derivative, oligothiophene of α-5- thiophene and their derivatives, phthalocyanine with or without metal and their derivatives, pyromellitic dianhydride and its derivative, pyromellitic diimide and its derivative, etc. In addition, a combination of at least two of the forgoing materials can be used for the organic semiconductor layer 15.

A thin film transistor according to the present invention can have a stacked structure as described above as well as other various stacked structures. For example, a thin film transistor according to the present invention can have a stacked structure in which a substrate, a gate electrode, an insulating layer, an organic semiconductor layer, and source and drain electrodes are sequentially stacked, or a stacked structure in which a substrate, source and drain electrodes, an organic semiconductor layer, an insulating layer, and a gate electrode are sequentially stacked.

A method of manufacturing a thin film transistor according to an embodiment of the present invention includes preparing a curable paste composition comprising conductive nano-particles, a curable resin, and a vehicle, applying the curable paste composition to a substrate, curing a portion of the curable paste composition to define at least one pattern of a gate electrode, a first conductive layer connected to the gate electrode, source and drain electrodes, and a second conductive layer connected to one of the source and drain electrodes, and removing an uncured portion of the curable paste composition to form the at least one of the gate electrode, the first conductive layer, the source and drain electrode, and the second conductive layer.

The curable paste composition contains conductive nano-particles and a curable resin. The conductive nano-particles are the same as described above. Examples of the curable resin include resins which are cured by light.

Optionally, the curable paste composition can further contain a vehicle. The vehicle controls the viscosity, printability, etc. of the curable paste composition, and the vehicle can at least partially volatilize during the curing process. Examples of the vehicle include, but are not limited to, TEOS, terpineol, butyl carbitol (BC), butyl carbitol acetate (BCA), toluene, texanol, a combination of at least two of the forgoing materials, etc.

The curable paste composition according to the present invention has a viscosity of 10-100 cps, for example, 20-90 cps (1 cps = 1 mPa·s). If the viscosity of the curable paste composition does not lie within this range, flowability and printability deteriorates, thus making it difficult to form a precise pattern.

The curable paste composition prepared above is applied to a substrate. The substrate refers to a support with a region in which at least one of a gate electrode, a first conductive layer connected to the gate electrode, source and drain electrodes, and a second conductive layer connected to one of the source and drain electrodes will be formed. A suitable substrate can be chosen according to the structure of a thin film transistor to be formed. For example, when forming a thin film transistor in which a gate electrode, an organic semiconductor layer, and source and drain electrodes are sequentially stacked, the curable paste composition is applied to a glass or plastic substrate to form the gate electrode. Next, the curable paste composition is applied to the substrate with the gate electrode and the organic semiconductor layer to form the source and drain electrodes.

After the curable paste composition is applied, the curable paste composition is cured to define a target pattern, for example, at least one of the gate electrode, the first conductive layer connected to the gate electrode, the source and drain electrodes, and the second conductive layer connected to at least one of the source and drain electrodes.

In the method according to the present invention, the curable paste composition undergoes a localized curing process by using a laser. A laser, which is a light source with a high energy density, can locally radiate heat or light along an ultra-fine pattern. Lasers which can be used in the present invention include a UV laser, an IR laser, etc. For example, a semiconductor laser with a 635-nm wavelength, an argon laser with a 514-nm wavelength, etc., can be used.

After the curing process, the uncured paste composition is removed. The uncured curable paste composition can be removed using various solvents, such as acetone, which can dissolve the uncured resin described above. When the curable resin contains hydrophilic groups, such as carboxyl groups, an water-soluble organic alkali compound, for example tetramethyl ammonium hydroxide, choline, trimethyl-2-hydroxyethyl ammonium hydroxide, etc. can instead be used. However, available solvents are not limited thereto.

As described above, a pattern of the curable paste composition according to the present invention is obtained by a localized curing process. In other words, the substrate and/or the organic semiconductor layer of a thin film transistor according to the present invention are not exposed to a high-temperature condition during the manufacturing of the thin film transistor. Therefore, thermal damage in the substrate and in the organic semiconductor layer of the thin film transistor according to the present invention is substantially prevented. In addition, according to the present invention, since the localized curing process is used, there is no need to perform complicated photoresist processes. Roll-to-roll continuous processes can instead be used, thus improving productivity.

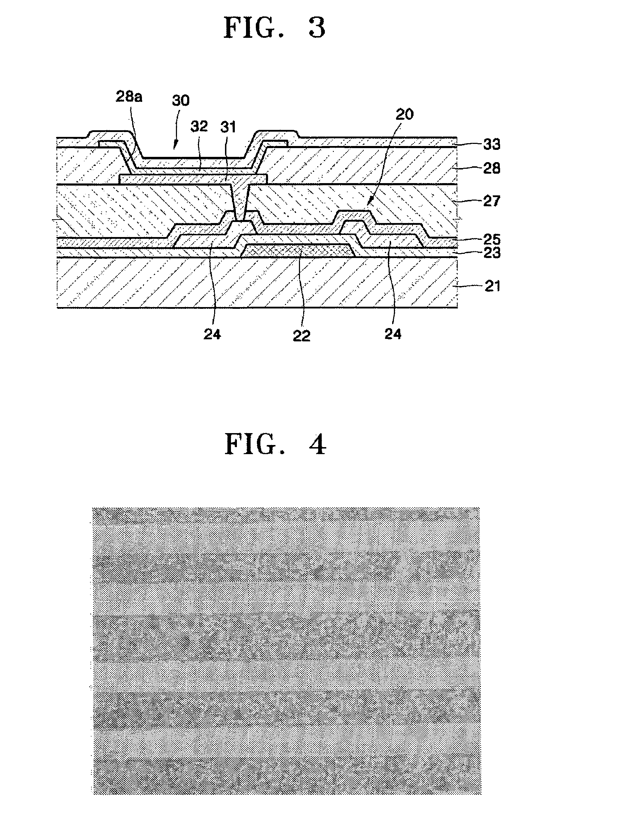

The thin film transistor according to the present invention described above and a thin film transistor manufactured using the method according to the present invention described above can be used in a flat panel display device, such as an LCD, an OLED, etc. Turning now to FIG. 3, FIG. 3 illustrates an exemplary organic light emitting display including the TFT according to the present invention. In FIG. 3, one sub-pixel of an organic light emitting display is shown. Each sub-pixel in an organic light emitting display includes a self-luminous device, i.e., an organic light emitting device (hereinafter, "OLED") and at least one thin film transistor. Although not illustrated, each sub-pixel also includes a capacitor.

The organic light emitting display has various pixel patterns, for example, red (R), green (G), and blue (B) pixel patterns, according to the colors of light emitted by OLEDs. Referring to FIG. 3, each of the R, G, and B sub-pixels includes a TFT structure and an OLED. A TFT in each of the sub-pixels can be a TFT described in the above embodiments. However, the TFT in each of the sub-pixel is not limited to the TFT describe above and can have other various structures.

Referring to FIG. 3, a TFT 20 having the above-described structure is formed on a substrate 21. A gate electrode 22 and source and drain electrodes 24 of the TFT 20 contain conductive nano-particles and a cured resin as described above. Although not illustrated in FIG. 3, a first conductive layer connected to the gate electrode 22 and/or a second conductive layer connected to one of the source and drain electrodes 24 can contain conductive nano-particles and a cured resin. The gate electrode 22, an insulating layer 23, and an organic semiconductor layer 25 of the TFT 20 are the same as those described above. Therefore, descriptions thereof will not be repeated here.

After the organic semiconductor layer 25 of the TFT 20 is formed, a passivation layer 27 is formed such as to cover the TFT 20. The passivation layer 27 can be a single or a multi-layered structure. The passivation layer can be formed of an organic material, an inorganic material, or a composite of organic and inorganic materials.

A first electrode 31 of the OLED 30 is formed on the passivation layer 27, and a pixel defining layer 28 is formed thereon. A predetermined opening 28a is formed in the pixel defining layer 28, and an organic emission layer 32 of the OLED 30 is formed.

The OLED 30 displays predetermined image information by emitting red, green, and blue light according to the flow of current. The OLED 30 includes the first electrode 31 connected to one of the source and drain electrodes 24 of the TFT 20, a second electrode 33 fully covering the pixel, and an organic emission layer 32 arranged between the first electrode 31 and the second electrode 33. The first electrode 31 connected to one of the source and drain electrodes 24 of the TFT 20 can be a pixel electrode. It is also to be appreciated that the present invention can also be applied to other various organic light emitting displays.

The organic emission layer 32 can be a small-molecular weight or large-molecular weight organic layer. When a small-molecular weight organic layer is used, a structure can include a hole injection layer (HIL), a hole transport layer (HTL), an emission layer (EML), an electron transport layer (ETL), an electron injection layer (EIL), etc. and can be stacked as a single layer or as multiple layers. Available organic materials for the organic emission layer 32 include copper phthalocyanine (CuPc), N,N'-di(naphthalene-1-yl)-N,N'-diphenyl-benzidine (NPB), tris-8-hydroxyquinoline aluminum (Alq3), etc. The small-molecular weight organic layer can be formed using a vacuum deposition method.

When a large-molecular weight organic layer is used, the organic emission layer 32 can have a structure including a HTL and an EML. In this case, the HTL is formed of PEDOT (Poly-3,4-Ethylenedioxythiophene), and the EML is formed of a large-molecular weight organic material, such as polyphenylenevinylenes (PPV), polyfluorenes, etc. The large-molecular weight organic layer can be formed using a screen printing method or an inkjet printing method. It is to be appreciated that the present invention is in no way limited to that above as other various organic layers can instead be used.

The first electrode 31 serves as an anode electrode, and the second electrode 33 serves as a cathode electrode. The polarities of the first electrode 31 and the second electrode 33 however can be inverted and still be within the scope of the present invention.

As described above, a thin film transistor according to the present invention can be mounted in each sub-pixel as illustrated in FIG. 3 as well as in a driver circuit (not shown) which does not produce images.

The following examples are for illustrative purposes only.

### Example 1

A photoresist ink (available from Clariant Co.) as a curable resin and an Ag ink (available from Cabot Co., average Ag particle diameter: 30 nm) containing Ag particles as conductive nano-particles were mixed in a weight ratio of 9:1. The mixture was spin-coated on a surface of a glass substrate at 900 rpm for 30 seconds and soft-baked at 110°C for 2 minutes and 30 seconds. The resulting structure was exposed with an energy of 25mJ/cm² for 5 seconds according to a pattern of a first conductive layer and immersed in a developing solution for 60 seconds for development. The resulting structure was hard-baked at 130°C for 3 minutes to obtain a pattern having a 15-µm width and a 1-µm height. As is apparent from a transmission electron microscopic (TEM) photograph of FIG. 4, the first pattern is formed.

### Example 2

5% by weight of a Poly Vinyl Alcohol (PVA) solution as a curable resin and an Ag ink (available from Cabot Co., average Ag particle diameter: 30 nm) containing Ag particles as conductive nano-particles was mixed in a weight ratio of 9:1. The mixture was spin-coated on a surface of a glass substrate with a photoresist pattern for a first conductive layer at 1000 rpm for 30 seconds and dried at room temperature for 10 minutes. The resulting structure was exposed with an energy of 600 mJ/cm² for 120 seconds according to a pattern of a first conductive layer and immersed in a developing solution for 60 seconds for development. The resulting structure was hard-baked at 100°C for 20 minutes to obtain a pattern with 15-µm width and 1-µm height.

As described above, conductive layers in a TFT are formed by a localized curing method using, for example, a laser. Therefore, TFTs with conductive layers in precise patterns can be manufactured at low-cost, and at low-temperature for a roll-to-roll continuous process, thus improving productivity. Also, a flat panel display with improved reliability can be manufactured using the TFT according to the present invention.

## Claims

1. A method of manufacturing an organic thin film transistor (10), the method comprising:
preparing a curable paste composition comprising conductive nano-particles and a curable resin, wherein a specific surface area of the conductive nano-particles is in the range of 2.0-10.0 m²/g, an average particle diameter of the conductive nano-particles is in the range of 10-100, nm, and the curable paste composition has a viscosity of in the range of 10-100 cps (1cps = 1mPa·s);
applying the curable paste composition to a substrate (11);
curing a portion of the curable paste composition to define at least one pattern of a gate electrode (12), a first conductive layer (12a) connected to the gate electrode (12), source and drain electrodes (14), and a second conductive layer (14a) connected to one of the source and drain electrodes (14); and
removing an uncured portion of the curable paste composition to form the at least one of the gate electrode (12), the first conductive layer (12a), the source and drain electrode (14), and the second conductive layer (14a) after the curing, wherein the curing of the portion of the curable paste composition is performed using either an ultraviolet laser or an infrared laser.

2. The method of claim 1, wherein the conductive nano-particles are selected from the group consisting of Au, Ag, Cu, Ni, Pt, Pd, and Al nano-particles.

3. The method of claim 1, wherein the cured resin is produced by curing at least a material selected from the group consisting of phthalate resins, epoxy resins, urea resins, melamine resins, acetylene resins, pyrrole resins, thiophene resins, olefin resins, alcohol resins, and phenol resins.

4. The method of claim 1, wherein the cured resin is obtained by curing at least one curable resin selected from the group consisting of polyethylene phthalate, polybutylene phthalate, polydihydroxymethylcyclohexyl terephthalate, urea-formaldehyde resin, melamine (2,4,6-triamino-1,3,5-triazine)-formaldehyde resin, melamine-urea resin, melamine-phenol resin, polyacetylene, polypyrrole, poly(3-alkylthiophene), polyphenylene vinylidene, polyethylene vinlidene, and polyvinyl alcohol.

5. The method of claim 1, wherein an organic semiconductor layer is provided in contact with the source and drain electrodes (14) and wherein the organic semiconductor layer is produced from at least one material selected from the group consisting of pentacene, tetracene, anthracene, naphthalene, α-6-thiophene; α-4-thiophene, perylene and its derivative, rubrene and its derivative, coronene and its derivative, perylene tetracarboxylic diimide and its derivative, perylene tetracarboxylic dianhydride and its derivative, polythiophene and its derivative, polyparaphenylene vinylene and its derivative,
polyparaphenylene and its derivative, polyfluorene and its derivative, polythiophene vinylene and its derivative, polythiophene-heterocyclic aromatic copolymer and its derivative, oligoacene of naphthalene and their derivative, oligothiophene of α-5- thiophene and their derivatives, phthalocyanine with or without metal and their derivatives, pyromellitic dianhydride and its derivative, and pyromellitic diimide and its derivative.

6. The method of claim 1, wherein the curable paste composition further comprises at least one vehicle selected from the group consisting of terpineol, butyl carbitol (BC), butyl carbitol acetate (BCA), toluene, and texanol.

## Patentansprüche

1. Verfahren zur Herstellung eines organischen Dünnfilmtransistors (10), wobei das Verfahren aufweist:
Herstellung einer härtbaren Pastenzusammensetzung, die leitfähige Nanopartikel und ein härtbares Harz aufweist, wobei eine spezifische Oberfläche der leitfähigen Nanopartikel im Bereich von 2,0-10,0 m²/g liegt, ein mittlerer Partikeldurchmesser der leitfähigen Nanopartikel im Bereich von 10-100 nm liegt und die härtbare Pastenzusammensetzung eine Viskosität im Bereich von 10-100 cps (1 cps = 1 mPa·s) aufweist;
Aufbringen der härtbaren Paste auf ein Substrat (11);
Härten eines Bereichs der härtbaren Pastenzusammensetzung, so dass zumindest ein Muster einer Gate-Elektrode (12), einer ersten leitenden Schicht (12a), die mit der Gate-Elektrode (12) verbunden ist, einer Source- und einer Drain-Elektrode (14) und einer zweiten leitenden Schicht (14a), die mit einer der Source- und Drain-Elektrode (14) verbunden ist, definiert wird; und
Entfernen eines nicht gehärteten Bereichs der härtbaren Pastenzusammensetzung, so dass nach dem Härten die zumindest eine der Gate-Elektrode (12), der ersten leitenden Schicht (12a), der Source- und Drain-Elektrode (14) und der zweiten leitenden Schicht (14a) ausgebildet wird, wobei das Härten des Bereichs der härtbaren Pastenzusammensetzung entweder mittels eines UV-Lasers oder eines Infrarotlasers durchgeführt wird.

2. Verfahren nach Anspruch 1, wobei die leitfähigen Nanopartikel aus der Gruppe bestehend aus Au-Nanopartikeln, Ag-Nanopartikeln, Cu-Nanopartikeln, Ni-Nanopartikeln, Pt-Nanopartikeln, Pd-Nanopartikeln und Al-Nanopartikeln ausgewählt sind.

3. Verfahren nach Anspruch 1, wobei das gehärtete Harz durch Härten zumindest eines Materials hergestellt wird, das aus der Gruppe bestehend aus Phthalatharzen, Epoxidharzen, Harnstoffharzen, Melaminharzen, Acetylenharzen, Pyrrolharzen, Thiophenharzen, Olefinharzen, Alkoholharzen und Phenolharzen ausgewählt ist.

4. Verfahren nach Anspruch 1, wobei man das gehärtete Harz durch Härten von zumindest einem härtbaren Harz erhält, das aus der Gruppe bestehend aus Polyethylenphthalat, Polybutylenphthalat, Polydihydroxymethylcyclohexylterephthalat, Harnstoffharz, Melamin (2,4,6-Triamino-1,3,5-triazin)-formaldehydharz, Melaminharnstoffharz, Melaminphenolharz, Polyacetylen, Polypyrrol, Poly(3-Alkylthiophen), Polyphenylenvinyliden, Polyethylenvinyliden und Polyvinylalkohl ausgewählt ist.

5. Verfahren nach Anspruch 1, wobei eine mit der Source- und Drain-Elektrode (14) in Kontakt befindliche organische Halbleiterschicht bereitgestellt wird und wobei die organische Halbleiterschicht aus zumindest einem Material hergestellt wird, das aus der Gruppe bestehend aus Pentacen, Tetracen, Anthracen, Naphthalin, α-6-Thiophen, α-4-Thiophen, Perylen und seinem Derivat, Rubren und seinem Derivat, Coronen und seinem Derivat, Perylentetracarboxyldiimid und seinem Derivat, Perylentetracarboxyldianhydrid und seinem Derivat, Polythiophen und seinem Derivat, Polyparaphenylenvinylen und seinem Derivat, Polyparaphenylen und seinem Derivat, Polyfluoren und seinem Derivat, Polythiophenvinylen und seinem Derivat, einem polythiophen-heterocyclischen aromatischen Copolymer und seinem Derivat, Oligoacen von Naphthalin und ihrem Derivat, Oligotiophen von α-5-Thiophen und ihren Derivaten, Phthalocyanin mit oder ohne Metall und ihren Derivaten, Pyromellitdianhydrid und seinem Derivat und Pyromellitdiimid und seinem Derivat ausgewählt ist.

6. Verfahren nach Anspruch 1, wobei die härtbare Pastenzusammensetzung weiterhin zumindest einen Träger aufweist, der aus der Gruppe bestehend aus Terpineol, Butylcarbitol (BC), Butylcarbitolacetat (BCA), Toluol und Texanol ausgewählt ist.

## Revendications

1. Procédé pour la production d'un transistor organique à couches minces (10), le procédé comprenant :
la préparation d'une composition en pâte durcissable comprenant des nanoparticules conductrices et une résine durcissable, la surface spécifique des nanoparticules conductrices étant comprise dans l'intervalle de 2,0 à 10,0 m²/g, le diamètre moyen de particule des nanoparticules conductrices étant compris dans l'intervalle de 10 à 100 nm, et la composition en pâte durcissable ayant une viscosité dans l'intervalle de 10 à 100 cps (1 cps = 1 mPa.s) ;
l'application de la composition en pâte durcissable à un substrat (11) ;
le durcissement d'une portion de la composition en pâte durcissable pour définir au moins un motif d'une électrode de grille (12), d'une première couche conductrice (12a) connectée à l'électrode de grille (12), d'électrodes de source et de drain (14) et d'une seconde couche conductrice (14a) connectée à une des électrodes de source et de drain (14) ; et
l'élimination d'une portion non durcie de la composition en pâte durcissable pour former ladite au moins une de l'électrode de grille (12), de la première couche conductrice (12a), des électrodes de source et de drain (14), et de la seconde couche conductrice (14a) après durcissement, dans lequel le durcissement de la portion de la composition en pâte durcissable est effectué en utilisant un laser à ultraviolet ou un laser à infrarouge.

2. Procédé suivant la revendication 1, dans lequel les nanoparticules conductrices sont choisies dans le groupe consistant en des nanoparticules de Au, Ag, Cu, Ni, Pt, Pd et Al.

3. Procédé suivant la revendication 1, dans lequel la résine durcie est produite par durcissement d'au moins une matière choisie dans le groupe consistant en des résines de phtalate, des résines époxy, des résines d'urée, des résines de mélamine, des résines d'acétylène, des résines de pyrrole, des résines de thiophène, des résines oléfiniques, des résines d'alcools et des résines phénoliques.

4. Procédé suivant la revendication 1, dans lequel la résine durcie est obtenue par durcissement d'au moins une résine durcissable choisie dans le groupe consistant en le poly(phtalate d'éthylène), le poly(phtalate de butylène), le poly(téréphtalate de dihydroxyméthylcyclohexyle), une résine urée-formaldéhyde, une résine de mélamine (2,4,6-triamino-1,3,5-triazine)-formaldéhyde, une résine de mélamine-urée, une résine de mélamine-phénol, le polyacétylène, le polypyrrole, un poly(3-alkylthiophène), le polyphénylène-vinylidène, le polyéthylène-vinylidène et l'alcool polyvinylique.

5. Procédé suivant la revendication 1, dans lequel une couche semi-conductrice organique est fournie en contact avec les électrodes de source et de drain (14) et dans lequel la couche semi-conductrice organique est produite à partir d'au moins une matière choisie dans le groupe consistant en le pentacène, le tétracène, l'anthracène, le naphtalène, l'α-6-thiophène, l'α-4-thiophène, le pérylène et son dérivé, le rubrène et son dérivé, le coronène et son dérivé, le diimide pérylènetétracarboxylique et son dérivé, le dianhydride pérylènetétracarboxylique et son dérivé, le polythiophène et son dérivé, le polyparaphénylène-vinylène et son dérivé, le polyparaphénylène et son dérivé, le polyfluorène et son dérivé, le polythiophène-vinylène et son dérivé, un copolymère polythiophène-monomère aromatique hétérocyclique et son dérivé, l'oligoacène de naphtalène et ses dérivés, l'oligothiophène d'α-5-thiophène et ses dérivés, la phtalocyanine avec ou sans métal et ses dérivés, le dianhydride pyromellitique et son dérivé et le diimide pyromellitique et son dérivé.

6. Procédé suivant la revendication 1, dans lequel la composition en pâte durcissable comprend en outre au moins un véhicule choisi dans le groupe consistant en le terpinéol, le butylcarbitol (BC), l'acétate de butylcarbitol (BCA), le toluène et le texanol.
